# EUROPEAN PATENT APPLICATION

(11) **EP 1 990 311 A1**
(43) Date of publication of application: **12.11.2008**
(21) Application number: 07714441.8
(22) Date of filing: 19.02.2007
(51) Int. Cl.: C01B 25/08, C01B 19/04, C09K 11/08, C09K 11/70, C09K 11/88

(54) **METHOD AND APPARATUS FOR MANUFACTURING SEMICONDUCTOR NANOPARTICLES**

(30) Priority: 27.02.2006 JP 2006049724
(71) Applicant: Idemitsu Kosan Co., Ltd., Chiyoda-ku Tokyo 100-8321 (JP)
(72) Inventor: HACHIYA, Satoshi, Sodegaura-shi, Chiba 2990293 (JP)
(74) Representative: Gille Hrabal Struck Neidlein Prop Roos
(86) International application number: PCT/JP2007/052915
(87) International publication number: WO 2007/099794

(57) **Abstract**

A method for producing semiconductor nanoparticles, wherein a reaction for forming nuclei of the semiconductor nanoparticles and a reaction for growing the nuclei of the semiconductor nanoparticles are performed in a stepwise manner, and an apparatus (1) for producing semiconductor nanoparticles including a continuous reaction apparatus (40) for performing a reaction for forming nuclei of semiconductor nanoparticles and a batch reaction apparatus (70) for performing a reaction for growing the semiconductor nanoparticles.

## Description

### TECHNICAL FIELD

The invention relates to the method and the apparatus for manufacturing semiconductor nanoparticles.

### BACKGROUND

Semiconductor nanoparticles have attracted attention as a highly durable fluorescent material.
If semiconductor nanoparticles are used in a display utilizing a color conversion medium (CCM), it is required to adjust the fluorescent peak wavelength of the semiconductor nanoparticles to be in the green or red region, as well as to allow the full width at half max thereof to be 80 nm or less.
To adjust the fluorescent wavelength to a desired value in semiconductor nanoparticles, the particle size of semiconductor nanoparticles is required to be controlled accurately. Under such circumstances, a more accurate and efficient method for producing semiconductor nanoparticles has been in demand.

Patent Document 1 discloses fluorescent semiconductor nanoparticles obtained by using only a batch reaction apparatus. Since the formation and growth of the nuclei of semiconductor nanoparticles are conducted in the same reaction apparatus, the nuclei of semiconductor nanoparticles are formed and grown at the same time, resulting in difficulty in particle size control of the semiconductor nanoparticles. In this method, therefore, the particle size of only a limited kind of semiconductor can be controlled.

In Patent Documents 2 and 3, a technology is disclosed in which the formation and growth of the nuclei of semiconductor nanoparticles are conducted separately by using only a continuous reaction apparatus and controlling the temperature of a reaction tube. However, in a continuous reaction apparatus, it is difficult to optimize the nuclei-forming and nuclei-growing reaction conditions. In addition, the reaction tube may be plugged with the growth of semiconductor nanoparticles. Furthermore, if the growth speed of the semiconductor nanoparticles is slow, the reaction tube has to be larger and longer. As a result, the resistance of the supplied liquid is increased, resulting in an increase in energy required for the production.

Furthermore, a technology of forming different sorts of semiconductor layers (shell) on the surfaces of semiconductor nanoparticles to protect the semiconductor nanoparticles is known (Patent Document 4). In the synthesis of a shell, it is known that dropwise addition of shell raw materials is effective to suppress the formation of nanoparticles composed only of a shell. However, such a gradual addition of the raw materials is difficult by using the continuous reaction apparatus alone.
Patent Document 1: JP-A-2001-523758
Patent Document 2: USP 6,179,912
Patent Document 3: JP-A-2003-160336
Patent Document 4: USP 6,322,901

### SUMMARY OF THE INVENTION

The object of the invention is to provide the method and the apparatus for producing semiconductor nanoparticles capable of controlling accurately the particle size.

According to the invention, the following method for producing semiconductor nanoparticles, and the like are provided.
1. A method for producing semiconductor nanoparticles, wherein a reaction for forming nuclei of the semiconductor nanoparticles and a reaction for growing the nuclei of the semiconductor nanoparticles are performed in a stepwise manner.
2. The method for producing semiconductor nanoparticles according to 1, wherein the reaction for forming nuclei comprises:
   mixing a reaction solvent and raw materials of semiconductor nanoparticles to obtain a mixture;
   heating the mixture to form nuclei of semiconductor nanoparticles; and
   after the formation of the nuclei, cooling the mixture to suppress the growth of the nuclei and the formation of new nuclei.
3. The method for producing semiconductor nanoparticles according to 2, wherein the time for heating the mixture until it reaches a temperature sufficient for the formation of the nuclei is 1 minute or less, and the time for cooling the mixture until it reaches a temperature sufficient for the suppression of growth of the nuclei and the formation of new nuclei is 1 minute or less.
4. The method for producing semiconductor nanoparticles according to any one of 1 to 3, wherein the reaction for the growth of nuclei comprises:
   adding raw materials of semiconductor nanoparticles to the nuclei; and
   heating the nuclei and the raw materials of the semiconductor nanoparticles to allow the nuclei to grow.
5. The method for producing the semiconductor nanoparticles according to 4, wherein the raw materials of the semiconductor nanoparticles are added gradually.
6. The method for producing semiconductor nanoparticles according to any one of 1 to 5, wherein the reaction for forming nuclei is performed in a continuous reaction apparatus and the reaction for growing the nuclei is performed in a batch reaction apparatus.
7. The method for producing semiconductor nanoparticles according to 6, wherein the continuous reaction apparatus is a microreactor.
8. The method for producing semiconductor nanoparticles according to any one of 1 to 7, wherein, after the growth of the nuclei, raw materials of a shell are further added to form a shell.
9. An apparatus for producing semiconductor nanoparticles comprising a continuous reaction apparatus for performing a reaction for forming nuclei of semiconductor nanoparticles and a batch reaction apparatus for performing a reaction for growing the semiconductor nanoparticles.
10. The apparatus for producing semiconductor nanoparticles according to 9, wherein the continuous reaction apparatus is a microreactor.

The invention provides a method and an apparatus for producing semiconductor nanoparticles capable of controlling the particle size with a high degree of accuracy.
According to the method for producing semiconductor nanoparticles of the invention, it is possible to control the particle size of the semiconductor nanoparticles with a high degree of accuracy since the nuclei of the semiconductor nanoparticles can be formed and grown at optimum conditions. As a result, semiconductor nanoparticles with a desired emission wavelength can be obtained.

### BRIER DESCRIPTION OF THE DRAWINGS

FIG. 1 is a schematic view showing an apparatus for producing semiconductor nanoparticles used in Examples; and
FIG. 2 is a schematic view showing an internal structure of a microreactor.

### BEST MODE FOR CARRYING OUT THE INVENTION

The characteristic feature of the method for producing semiconductor nanoparticles is that a reaction for forming nuclei (nuclei-forming reaction) and a reaction for growing the nuclei (nuclei-growing reaction) are performed in a stepwise manner.
Here, the expression "stepwise" means that, the growth reaction is not performed with the condition after the nuclei formation being maintained. Specifically, after the nuclei are formed, the nuclei formation is stopped by decreasing the temperature, and the nuclei are then allowed to grow by elevating the temperature. The nuclei-forming reaction and the nuclei-growing reaction may be performed either on the same location or on different locations. The nuclei-growing reaction may be performed immediately after the nuclei-forming reaction, or may be performed at certain time intervals.

### (1) Nuclei-forming reaction

The nuclei-forming reaction is a reaction for forming the nuclei of semiconductor nanoparticles from raw materials of semiconductor nanoparticles.
This reaction, for example, comprises mixing a reaction solvent and raw materials of semiconductor nanoparticles to obtain a mixture, heating the mixture to form nuclei of the semiconductor nanoparticles, and cooling to suppress growth of the nuclei and formation of new nuclei.

When the nuclei of the semiconductor nanoparticles are formed by heating, it is preferred that the inside of the reaction system be heated rapidly. The time for heating the inside of the reaction system until the mixture reaches a temperature sufficient for the formation of the nuclei is preferably 1 minute or less, more preferably 30 seconds or less. If it takes a long time until the mixture reaches a temperature sufficient for the formation of the nuclei, the raw materials may be decomposed, resulting in a decrease in the yield of the semiconductor nanoparticles.
Although the temperature at which the nuclei of semiconductor nanoparticles are formed depends on the type of a semiconductor to be produced or raw materials used, it is normally 280 to 350°C in the case of InP, for example.

After the nuclei of the semiconductor nanoparticles are formed, to suppress the growth of the nuclei and the formation of new nuclei by cooling the inside of the reaction system, it is preferable to perform rapid cooling. The time taken until the cooled mixture has a temperature which is below the nuclei growth temperature is preferably 1 minute or less, more preferably 30 seconds or less. If it takes a long time until the reaction system reaches a temperature sufficient for the suppression of nuclei formation, the nuclei which have already formed may continue to grow, and at the same time, new nuclei may be formed to cause the particle size distribution to be large.
Although the cooling temperature which is below the growth temperature of semiconductor nanoparticles depends on the type of a semiconductor to be produced or raw materials used, it is normally 280°C or less in the case of InP, for example.

The particle size of the nuclei of the semiconductor nanoparticles composed of InP, which are formed by this reaction, is preferably 1 nm to 2 nm. The particle size of the nuclei of the semiconductor nanoparticles may be controlled by adjusting the heating time.

### (2) Growth reaction

The growth reaction is a reaction for growing the nuclei of semiconductor nanoparticles.
In this reaction, raw materials of the semiconductor nanoparticles and the nuclei of semiconductor nanoparticles produced by the above-mentioned reaction (1) are mixed in necessary amount, followed by heating to allow the semiconductor nanoparticles to grow.
Depending on the growth state of the particles, raw materials of the semiconductor nanoparticles may be added gradually. By this addition, the particle size of the semiconductor nanoparticles may be controlled.
Although the temperature at which the nuclei of semiconductor nanoparticles grow may vary depending on the kind of a semiconductor to be produced, it is normally 180 to 310°C in the case of InP, for example.
The particle size of the semiconductor nanoparticles composed of InP, which are formed by this reaction, is preferably 4 nm to 4. 8 nm, if green emission is intended to obtain. The particle size of the semiconductor nanoparticles can be adjusted by controlling the ratio of the raw materials of the semiconductor nanoparticles and the nuclei of the semiconductor nanoparticles, as well as the reaction time.

By performing the nuclei-forming reaction and the nuclei-growing reaction in different reaction systems, the condition of each reaction may be optimized and control of the particle diameter of the semiconductor particles may be facilitated.
As a result, in fluorescent semiconductor nanoparticles, sharp emission is obtained, and at the same time, control of emission wavelength is facilitated.

The apparatus for producing semiconductor nanoparticles of the invention comprises a continuous reaction apparatus and a batch reaction apparatus. Here, the continuous reaction apparatus is an apparatus in which raw materials are supplied from one side of the apparatus continuously and the formed product is taken out continuously from the other side. The batch reaction apparatus is an apparatus in which raw materials are supplied to the apparatus to allow the reaction to proceed, and raw materials for a next reaction are supplied after the reaction product of the initial reaction is taken out.
As mentioned above, the nuclei-forming reaction requires rapid heating and cooling within the reaction system. Therefore, it is preferred that the nuclei-forming reaction be performed in a continuous reaction apparatus in which the temperature control of the reaction system is easily performed.

Specific examples of the continuous reaction apparatus for performing the nuclei-forming reaction include a microreactor and a tubular reaction apparatus. A microreactor is particularly preferable.
A microreactor is a general term meaning a micro-sized reaction apparatus having a micro channel of several micrometers to several hundred micrometers in dimension.

On the other hand, it is preferred that the growth reaction be performed in a batch reaction apparatus to enable the reaction to be stopped after confirming the semiconductor nanoparticles have grown to have an intended particle size.

Although the method of the invention may be used for producing nanoparticles of all kinds of semiconductors, it is particularly effective for producing nanoparticles of II-VI semiconductors and nanoparticles of III-V semiconductors.
Examples of the II-V semiconductors include ZnTe, ZnSe and ZnS.
Examples of the III-V semiconductors include InP.

In the method for producing the semiconductor nanoparticles of the invention, known reaction solvents or raw materials may be used. For example, when semiconductor nano particles composed of InP are produced, trioctylphosphine oxide (TOPO), trioctylphosphine (TOP), 1-octadecene or the like may be used as a reaction solvent.

In the method for producing the semiconductor nanoparticles of the invention, it is possible to produce so-called core/shell semiconductor nanoparticles which are composed of a plurality of semiconductors.
The core-shell semiconductor nanoparticles can be produced by a method in which, after the nuclei of semiconductor nanoparticles are grown by the above-mentioned method, raw materials of semiconductor nanoparticles which are different from the raw materials of the semiconductor nanoparticles which constitute the nuclei are added, followed by a reaction.

### EXAMPLES

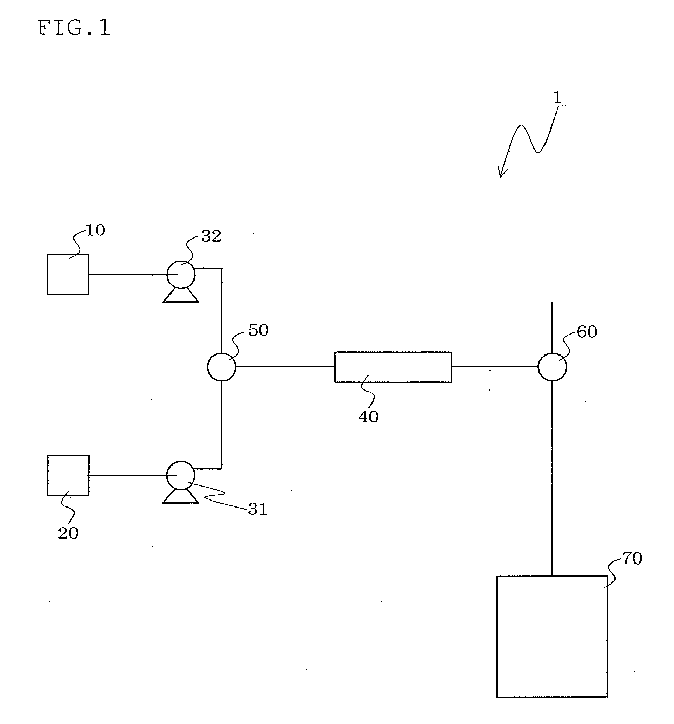

In the following examples, semiconductor nanoparticles are produced by using an apparatus shown in FIG. 1.
An apparatus 1 shown in FIG. 1 for producing semiconductor nanoparticles comprises a raw material vessel 10 to which raw materials are added, a solvent vessel 20 to which a reaction solvent is added, liquid-supply pumps 31 and 32, a microreactor 40, valves 50 and 60, and a batch reaction apparatus 70.
The raw material vessel 10 and the microreactor 40 are connected by a piping, with the liquid-supply pump 32 and the valve 50 being interposed therebetween in this order. The solvent vessel 20 and the microreactor 40 are connected by a piping, with the liquid-supply pump 31 and the valve 50 being interposed therebetween in this order. The microreactor 40 and the batch reaction apparatus 70 are connected by a piping, with the valve 60 being interposed therebetween.

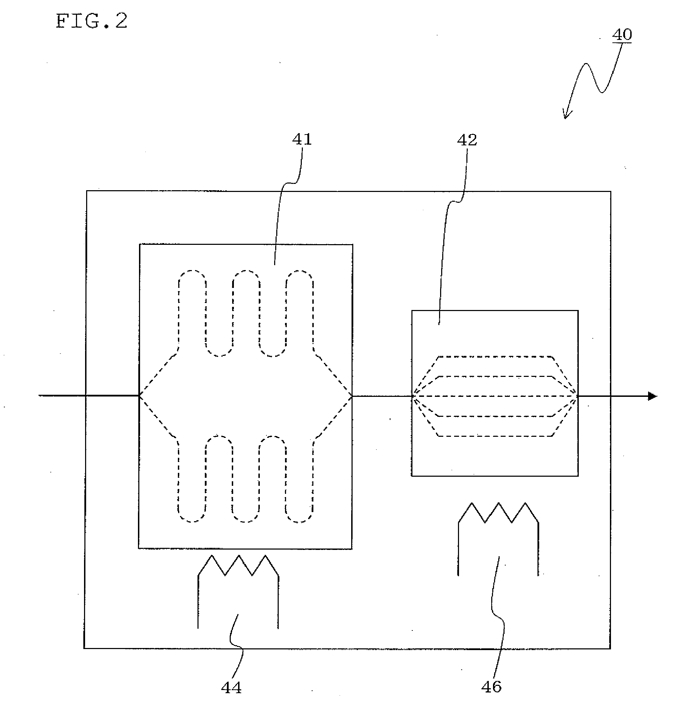

FIG. 2 is a schematic view showing the internal structure of the microreactor 40 shown in FIG. 1.
The microreactor 40 is provided with a heating part 41 and a cooling part 42. The heating part 41 is provided with a temperature-controlling device 44 which comprises a heater and a temperature sensor, and the cooling part 42 is provided with a temperature-controlling device 46 which comprises a coolant-circulating part and a temperature sensor. These parts adjust the temperature of the heating part 41 and the cooling part 42.
The piping arranged inside the microreactor 40 has the following configuration.
Heating part: Length: 120 cm, cross sectional area of a pipe: 0.0009 cm²
Cooling part: Length: 40 cm, cross sectional area of a pipe: 0.0009 cm²

### Example 1

### (1) Nuclei-forming reaction

4.3 g of trioctylphosphine oxide (TOPO), 3.2 g of trioctylphosphine (TOP), 0.26 g of indium chloride and 0.32 g of hexaethylphosphorous triamide were mixed, and vacuum-dried at 140°C for 1 hour. The dried mixture was put in the raw material vessel 10 which had been kept at 100°C under nitrogen atmosphere.
A reaction solvent obtained by mixing TOPO and TOP at the same weight ratio as mentioned above was put in the solvent vessel 20 which had been kept at 100°C under nitrogen atmosphere.
By means of the liquid-supply pump 31, the reaction solvent was sent to the microreactor 40 at a flow rate of 0.3 ml/min, in which the temperature of the heating part 41 was kept at 330°C, and the inside of the microreactor was kept at the stationary state. Furthermore, a medium which was kept at 100°C was supplied to the cooling part 42 so that the reaction solution could be cooled to 100°C. In addition, the part of the piping beyond the microreactor 40 was kept at 100°C.
After confirming that the inside the microreactor became the stationary state, the valve 50 was switched, and, by means of the liquid-supply pump 32, a raw material solution was supplied to the microreactor 40 for 75 seconds at a flow rate of 0.3 ml/min.
At a position which was 5 cm away from the inlet of the heating part 41, the reaction solution supplied already reached a temperature at which the nuclei of semiconductor nanoparticles composed of InP were formed (330°C). After leaving the inlet of the heating part 41, the reaction solution reached this position (the position 5 cm away from the inlet) within about 2 seconds.
After the reaction solution, which had passed the heating part 41, was introduced to the cooling part 42, at a position which was 3 cm away from the inlet of the cooling part 42, the reaction solution already reached a temperature which was below a temperature at which the nuclei of the semiconductor nanoparticles were formed or grown (180°C). After leaving the inlet of the heating part 42, the reaction solution reached this position (the position 3 cm away from the inlet) within about 4.5 seconds.
By this reaction, the nuclei of the semiconductor nanoparticles with a particle size of 1 nm to 1. 5 nm were formed. The particle size of the nuclei of the semiconductor nanoparticles were confirmed by a TEM observation.

### (2) Growth reaction

16 g of TOPO and 8 g of TOP, which had been vacuum-dried in advance, were put in a batch reaction apparatus 70 provided with a stirrer, and heated to 100°C under nitrogen atmosphere. By manipulating the valve 60 beyond the outlet of the microreactor, the reaction solution containing the nuclei of the semiconductor nanoparticles formed inside the microreactor was poured into the batch reaction apparatus 70.
Subsequently, a raw material solution (containing 4 g of TOP, 0.25 g of indium chloride and 0. 31 g of hexaethylphosphorus triamide) for the growth reaction of the semiconductor nanoparticles, which had been vacuum-dried in advance, was added to the batch reaction apparatus 70.
The reaction temperature was elevated to 300°C, and stirring was continued for 3 hours.
By this reaction, semiconductor nanoparticles composed of InP which were grown to have a particle size of 4.1 nm to 4.6 nm were obtained. The particle size of the semiconductor nanoparticles was measured by the dynamic laser scattering method.

### (3) Separation of the semiconductor nanoparticles

The reaction solution obtained in (2) above was cooled to 60°C. Then, 6 ml of 1-butanol was added, and the resultant was cooled to room temperature.
Then, 40 ml of dehydrated methanol was added, stirred for 30 seconds, and allowed to stand. The separated lower layer was collected.
3 ml of 1-butanol and 40 ml of acetonitrile were added to the collected lower layer. The resultant was stirred for 30 seconds, and allowed to stand. Then, the separated lower layer was collected. This operation was further repeated twice.
The solid matter separated by the above operation was collected by centrifugation (3,000 rpm, 10 minutes), re-dispersed in toluene, whereby a dispersion liquid of the semiconductor nanoparticles was obtained.
The resulting dispersion liquid of the semiconductor nanoparticles was exited by light with a wavelength of 450 nm. As a result, fluorescence with a peak wavelength of 530 nm and a full width at half max of 55 nm was observed.

### Example 2

### (1) Nuclei-forming reaction

1.6 g of TOP was added to 0.06 g of zinc acetate. The mixture was heated to 100°C under reduced pressure to dissolve the zinc acetate.
0.039 g of tellurium was dissolved in 0.3 g of hexapropylphosphorus triamide.
8 g of TOPO, which had been vacuum-dried in advance, and 0.015 g of myristic acid were put in the raw material vessel 10 which was kept at 100°C under nitrogen atmosphere. Then, the above-mentioned zinc acetate solution and the above-mentioned tellurium solution were added, thereby to obtain a raw material solution.
A reaction solvent obtained by mixing TOPO and TOP at the same weight ratio as that of the above-mentioned raw material solution was put in the solvent vessel 20 which had been kept at 100°C under nitrogen atmosphere.
The reaction solvent was supplied at a flow rate of 0.3 ml/min, by means of the liquid-supply pump 31, to the microreactor 40 in which the temperature of the heating part 41 was kept at 310°C and the temperature of the cooling part 42 was kept at 100°C. The inside of the microreactor 40 was kept at the stationary state.
After confirming that the inside of the microreactor became the stationary state, the valve 50 was switched, and, by means of the liquid-supply pump 32, a raw material was supplied to the microreactor 40 for 40 seconds at a flow rate of 0.3 ml/min.
At a position which was 5 cm away from the inlet of the heating part 41, the supplied reaction solution already had a temperature at which the nuclei of the semiconductor nanoparticles composed of ZnTe were formed (310°C). After leaving the inlet of the heating part 41, the reaction solution reached this position (the position which was 5 cm away from the inlet) within about 2 seconds.
After the reaction solution, which had passed the heating part 41, was introduced to the cooling part 42, at a position which was 3 cm away from the inlet of the cooling part 42, the reaction solution already had a temperature which was below the temperature at which the nuclei of semiconductor nanoparticles were formed (180°C). After leaving the inlet of the cooling part 42, the reaction solution reached this position (the position which was 3 cm away from the inlet) within about 4.5 seconds.
By this reaction, the nuclei of the semiconductor nanoparticles with a particle size of 3.3 nm to 3.8 nm were formed.

### (2) Growth reaction

10 g of a raw material solution having the same composition as in (1) above was put in the batch reaction apparatus 70, and heated to 200°C under a nitrogen atmosphere.
By manipulating the valve 60 beyond the outlet of the microreactor, the reaction solution containing the nuclei of the semiconductor nanoparticles formed inside the microreactor was poured into the batch reaction apparatus 70.
The reaction temperature was elevated to 280°C, and stirring was continued for 3 hours.
By this reaction, semiconductor nanoparticles composed of ZnTe which were grown to have a particle size of 6.6 nm to 7.5 nm (core part) were obtained.

### (3) Shell formation

The reaction solution obtained in (2) above was cooled to 150°C in the batch reaction apparatus 70. A shell raw material solution obtained by dissolving 0.22 ml of a 1 mol/l diethylzinc/hexane solution and 0.05 g of bis(trimethylsilyl)selenide in 2 g of TOP was added dropwise to the reaction solution for 30 minutes.
After the completion of the dropwise addition, stirring was continued at 150°C for 1 hour. Stirring was further continued at 100°C for 2 hours.
As a result, semiconductor nanoparticles with a particle size of 8 nm to 9 nm composed of a core part of ZnTe and a shell part of ZnSe were obtained.

### (4) Separation of semiconductor nanoparticles

The reaction solution obtained in (3) above was cooled to 60°C, 6 ml of 1-butanol was added, and the resultant was cooled to room temperature.
40 ml of acetonitrile was added. The resultant was stirred for 30 seconds and allowed to stand. The separated lower layer was collected.
Then, 3 ml of 1-butanol and 40 ml of acetonitrile were added to the collected lower layer. The resultant was stirred for 30 seconds, and allowed to stand. Then, the separated lower layer was collected. This operation was further repeated twice.
The solid matter separated by the above operation was collected by centrifugation (3,000 rpm, 10 minutes), re-dispersed in hexane, whereby a dispersion liquid of the semiconductor nanoparticles was obtained.
The resulting dispersion liquid of the semiconductor nanoparticles was excited by light with a wavelength of 450 nm. As a result, fluorescence with a peak wavelength of 522 nm and a full width at half max of 65 nm was observed.

### Comparative Example 1

### (1) Synthesis of semiconductor nanoparticles

2.0 g of trioctylphosphine oxide (TOPO), 1.75 g of trioctylphosphine (TOP), 0.26 g of indium chloride and 0.32 g of hexaethylphosphorous triamide were mixed, and vacuum-dried at 140°C for 1 hour, thereby to obtain a raw material solution.
14 g of TOPO and 10 g of TOP, which had been vacuum-dried in advance, were put in a batch reaction apparatus, and heated to 330°C under a nitrogen atmosphere. The above-mentioned raw material solution was poured at once to the reaction apparatus.
At that time, the temperature of the reaction solution was dropped to 275°C. Then, the temperature was elevated to 300°C for about 2 minutes.
While keeping the reaction temperature at 300°C, stirring was continued for 3 hours.
As a result, semiconductor nanoparticles composed of InP with a particle size of 3.8 nm to 5.2 nm were obtained.

### (2) Separation of semiconductor nanoparticles

The reaction solution obtained in (1) was subjected to a post-treatment in the same manner as in Example 1, whereby a dispersion liquid of semiconductor nanoparticles was obtained.
The resulting dispersion liquid of the semiconductor nanoparticles was exited by light with a wavelength of 450 nm. As a result, fluorescence with a peak wavelength of 530 nm and a full width at half max of 124 nm was observed.

When the semiconductor nanoparticles are continuously synthesized by using a batch reaction apparatus alone, the full width at half max of the fluorescence becomes large. If these semiconductor nanoparticles are used in a display as they are, the color purity of the display deteriorates.

### INDUSTRIAL APPLICABILITY

The semiconductor nanoparticles produced according to the method of the invention can be widely used in displays for industrial applications and commercial applications (portable, car-mounted, or indoor displays).

## Claims

1. A method for producing semiconductor nanoparticles, wherein a reaction for forming nuclei of the semiconductor nanoparticles and a reaction for growing the nuclei of the semiconductor nanoparticles are performed in a stepwise manner.

2. The method for producing semiconductor nanoparticles according to claim 1, wherein the reaction for forming nuclei comprises:
mixing a reaction solvent and raw materials of semiconductor nanoparticles to obtain a mixture;
heating the mixture to form nuclei of semiconductor nanoparticles; and
after the formation of the nuclei, cooling the mixture to suppress the growth of the nuclei and the formation of new nuclei.

3. The method for producing semiconductor nanoparticles according to claim 2, wherein the time for heating the mixture until it reaches a temperature sufficient for the formation of the nuclei is 1 minute or less, and the time for cooling the mixture until it reaches a temperature sufficient for the suppression of growth of the nuclei and the formation of new nuclei is 1 minute or less.

4. The method for producing semiconductor nanoparticles according to any one of claims 1 to 3, wherein the reaction for the growth of nuclei comprises:
adding raw materials of semiconductor nanoparticles to the nuclei; and
heating the nuclei and the raw materials of the semiconductor nanoparticles to allow the nuclei to grow.

5. The method for producing the semiconductor nanoparticles according to claim 4, wherein the raw materials of the semiconductor nanoparticles are added gradually.

6. The method for producing semiconductor nanoparticles according to any one of claims 1 to 5, wherein the reaction for forming nuclei is performed in a continuous reaction apparatus and the reaction for growing the nuclei is performed in a batch reaction apparatus.

7. The method for producing semiconductor nanoparticles according to claim 6, wherein the continuous reaction apparatus is a microreactor.

8. The method for producing semiconductor nanoparticles according to any one of claims 1 to 7, wherein, after the growth of the nuclei, raw materials of a shell are further added to form a shell.

9. An apparatus for producing semiconductor nanoparticles comprising a continuous reaction apparatus for performing a reaction for forming nuclei of semiconductor nanoparticles and a batch reaction apparatus for performing a reaction for growing the semiconductor nanoparticles.

10. The apparatus for producing semiconductor nanoparticles according to claim 9, wherein the continuous reaction apparatus is a microreactor.
